# EUROPEAN PATENT SPECIFICATION

(11) **EP 4 550 655 B1**
(45) Date of publication and mention of the grant of the patent: **27.05.2026**
(21) Application number: 24209033.0
(22) Date of filing: 25.10.2024
(51) Int. Cl.: H02P 6/16, G01D 3/02, G01D 5/14

(54) **MOTOR DRIVE CONTROLLER AND METHOD FOR CONTROLLABLY DRIVING MOTOR**
MOTORANTRIEBSSTEUERUNG UND VERFAHREN ZUM STEUERBAREN ANTRIEB EINES MOTORS
DISPOSITIF DE COMMANDE D'ENTRAÎNEMENT DE MOTEUR ET PROCÉDÉ D'ENTRAÎNEMENT DE MOTEUR POUVANT ÊTRE COMMANDÉ

(30) Priority: 31.10.2023 JP 2023186485
(43) Date of publication of application: 07.05.2025
(73) Proprietor: MITSUMI ELECTRIC CO., LTD., Tama-Shi, Tokyo 206-8567 (JP)
(72) Inventor: IMAI, Toshiyuki, TAMA-SHI, 206-8567 (JP); UESHIMA, Yasuyuki, TAMA-SHI, 206-8567 (JP); OHASHI, Takahiro, TAMA-SHI, 206-8567 (JP)
(74) Representative: Dennemeyer & Associates S.A.

(56) References cited:
- EP-A1- 3 226 401
- JP-A- S6 339 486
- US-A1- 2015 009 517
- US-A1- 2020 091 843

## Description

### BACKGROUND

### 1. Technical Field

The present disclosure relates to a motor drive controller and a method for controllably driving a motor.

### 2. Description of the Related Art

In order to rotate a brushless direct current (BLDC) motor, a magnet that is mounted on a rotor needs to detect the movement and changes in a magnetic field due to rotation of the rotor, and a Hall sensor is used in the detection of the magnetic field. The Hall sensor needs to be biased with a predetermined voltage to generate a magnetic field detection signal from the Hall sensor.
However, if a bias voltage is unstable, the magnetic field detection signal is directly affected and becomes unstable. In view of the above situation, the bias voltage to be applied to the Hall element is generated by a stabilization voltage source (regulator). In particular, increased power consumption of a regulator causes the temperature of a device to rise, and as a result, an operating condition may be restricted.

For example, Patent Document 1 discloses a control for intermittent operation of the Hall element. Examples of motor drive devices are described in EP 3226401 A1, which discloses the features of the preamble of claims 1 and 7, and further in US 2015/009517 A1, JP S63 39486 A, and US 2020/091843 A1.

### [Related-Art Document]

### [Patent Document]

Patent Document 1: Japanese Unexamined Patent Application Publication No. 2016-111912

### SUMMARY

According to the claimed invention, a motor drive controller and a method for controllably driving a motor as defined in the appended claims are provided.

### BRIEF DESCRIPTION OF THE DRAWINGS

FIG. 1 is a diagram illustrating a configuration example of a motor drive controller according to one embodiment.
FIG. 2 is a diagram illustrating a signal behavior by the motor drive controller during steady rotation in a comparative example.
FIG. 3 is a functional block diagram illustrating a bias adjuster according to the embodiment.
FIG. 4 is a circuit diagram illustrating a Hall bias output unit according to the embodiment.
FIG. 5 is a diagram for describing the signal behavior during steady rotation in the motor drive controller according to the embodiment.
FIG. 6 is an overall flowchart illustrating a bias control according to the embodiment.
FIG. 7 is a detailed flowchart for determination of whether to perform the bias control according to the embodiment.

### DETAILED DESCRIPTION

The inventors of this application have recognized the following information in related art. In Patent Document 1 described above, if the phase of the Hall voltage changes at a timing at which the Hall element is not biased in order to operate the Hall element intermittently, a timing of an actual phase change cannot be accurately detected. Although a modification circuit has been proposed in preparation for a case that cannot be detected in this technology, there are cases where detection of a precise and accurate timing cannot be assured, because corrections are made by predicting the phase change from a rotational signal period. Also, switching noise during an intermittent operation of the Hall element may be superimposed on a magnetic signal.

In view of the above situation, an object of the present disclosure is to provide a motor drive controller that reliably detects a timing of a phase change of magnetic signals, and that reduces a bias current during an unnecessary period without generating switching noise, thereby suppressing power consumption.

Various embodiments will be described below with reference to the drawings. In each drawing, the same components are denoted by the same numerals, and duplicate description may be omitted.

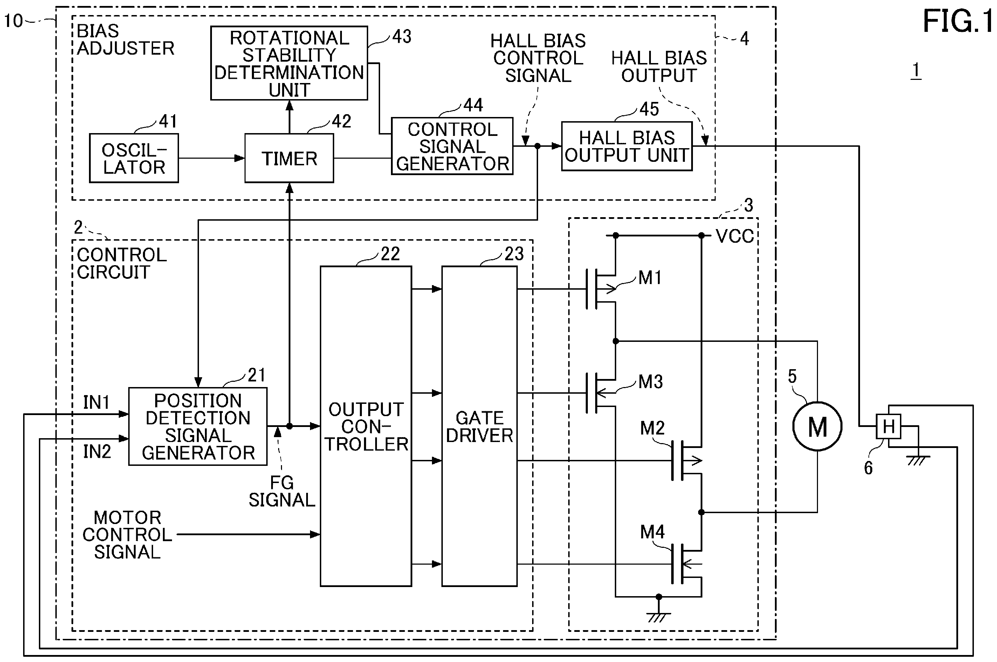

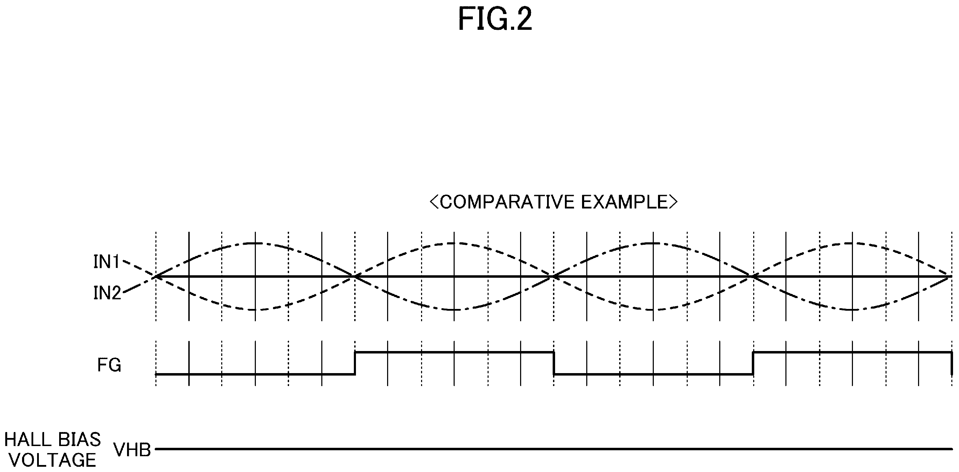

A configuration of a motor drive controller according to one embodiment will be described with reference to FIGS. 1 and 2. FIG. 1 is a diagram illustrating the configuration of the motor drive controller according to the embodiment.

A motor drive controller 1 is incorporated in a fan motor for cooling a heat generating component such as a processor in an electronic device, which includes, for example, a notebook personal computer or the like. A motor that is driven by the motor drive controller 1 is a brushless direct current (DC) motor (BLDC) with a Hall sensor that serves as a rotor-position detection element.

The motor drive controller 1 is a circuit that drives a single-phase motor 5 for rotating a cooling fan, for example. The motor drive controller 1 includes a drive controller 10, a single-phase motor 5, and a Hall element 6. The drive controller 10 includes a control circuit 2, an H-bridge circuit 3, and a bias adjuster 4. The control circuit 2 and the bias adjuster 4 may include one or more terminals and may constitute a control integrated circuit (IC) as a semiconductor integrated circuit for controlling a motor driver.

In the drive controller 10, the control circuit 2 includes a position detection signal generator 21, an output controller 22, and a gate driver 23. The control circuit 2 may also include circuits such as a PWM signal generator and a soft-switching period generator. Hall signals IN1 and IN2 are input to the control circuit 2 from the Hall element 6.

The H-bridge circuit 3 functions as a motor driver, and includes P-channel FETs M1 and M2, and N-channel FETs M3 and M4. A P-channel FET M1 functions as a first high-side switch, an N-channel-FET M4 functions as a first low-side switch, a P-channel FET M2 functions as a second high-side switch, and an N-channel FET M3 functions as a second low-side switch.

A rotor of the single-phase motor 5 has magnets with N and S poles, while the Hall element 6 is fixed in place so as to detect the magnetic field of the magnets provided in the rotor. The Hall element 6, which is a magnetic sensor, outputs, to terminals, the Hall signals IN1 and IN2 having voltage levels that correspond to the strength of a detected magnetic field. The magnet rotates with the rotation of the rotor, and the position of the rotor is detected by the Hall element 6 by detecting a change in the magnetic field caused by the rotation of the magnet. Each of the Hall signals IN1 and IN2 in the present embodiment is, for example, a sinusoidal signal whose amplitude has a predetermined voltage level. The Hall signals IN1 and IN2 are output to the respective terminals of the control IC in the drive controller 10. The Hall signals IN1 and IN2 are not limited to sinusoidal waves.

The bias adjuster 4 adjusts a level of a bias current that is applied to operate the Hall element 6. The bias adjuster 4 includes an oscillator 41, a timer 42, a rotation stability determination unit 43, a control signal generator 44, and a Hall bias output unit 45.

In the control circuit 2, a position-detection signal generator 21 compares the levels of the Hall signals IN1 and IN2, and generates a frequency generation (FG) signal (position detection signal), which is a signal whose frequency changes according to a rotational speed of the single-phase motor 5.

The position detection signal generator 21 generates the FG signal. The FG signal becomes high (which may be referred to as a "H" level) when the level of the Hall signal IN1 becomes higher than the level of the Hall signal IN2, while the FG signal becomes low (which may be referred to as a "L" level) when the level of the Hall signal IN1 becomes lower than the level of the Hall signal IN2. However, the position detection signal generator 21 performs a switching operation of the FG signal only during a time period in which the Hall element 6 outputs the Hall signals, based on the output of the bias adjuster 4.

The output controller 22 generates signals for switching the FETs M1, M2, M3, and M4 in the H-bridge circuit 3, and outputs the signals to the gate driver 23.

The gate driver 23 controls the MOSFETs of the H-bridge circuit 3, and changes a drive current Idr for energizing a motor coil L in the single-phase motor 5. Specifically, the gate driver 23 outputs gate control voltages for turning on and off the gates of the FETs M1, M2, M3, and M4 of the H-bridge circuit 3 individually.

The bias adjuster 4 is a circuit for adjusting a bias voltage, which corresponds to the strength of an electric field to be applied to the Hall element 6 to output, at an appropriate timing, the Hall signals that are magnetic field detection signals.

### <Comparative Example>

Hereinafter, a general behavior of a Hall bias in a case where the bias adjuster 4 is not provided will be described with reference to FIG. 2. FIG. 2 is a diagram illustrating a signal behavior during steady rotation in the motor drive controller in a comparative example.

In the related art, regardless of a state of the Hall signals IN1 and IN2, a bias voltage having a level that allows the Hall element to output the Hall signal outputs is constantly applied to the Hall element.

As an example, when the bias voltage is applied to the Hall element, a condition in which the bias voltage is 1.0 V from 1.3 V, impedance of the Hall sensor is 200 Ω to 500 Q, and the bias current is 2 mA to 7 mA is satisfied.

For example, when a power voltage is 24 V, a regulator output voltage is 1.3 V, and the bias current is 5 mA, the Hall sensor consumes power of 6.5 mW, derived from 1.3 V x 5 mA, and the regulator output unit consumes power of 113.5 mW, derived from (24 V - 1.3 V) x 5 mA.

Here, if the bias voltage is unstable, a magnetic field detection signal is directly affected and becomes unstable, and thus the Hall element is biased by a stabilization voltage source (regulator). In particular, increased power consumption of the regulator causes a temperature of a device to rise, which may constrain an operating condition.

However, in order to rotate the BLDC motor, it is only necessary to identify a timing of the phase change (which corresponds to switching between magnetic fields N and S), and it is not necessary to constantly flow the bias current. Specifically, when a point where Hall signals IN1 and IN2 have the same potential is reached, the output of the FG signal, which is a position detection signal in a subsequent stage, is inverted, and a timing of switching of FG signal output is used in a subsequent control. As long as the timing of switching of FG signal output, that is, a timing at which the Hall signals IN1 and IN2 have the same potential is identified, it is not necessary to apply the bias current at a level capable of outputting the Hall signals during a time period other than the timing identified above.

Therefore, in the present disclosure, by providing the bias adjuster 4, the bias voltage is greatly reduced during a time period other than a given timing necessary for control, that is, during a time period other than a predetermined time period immediately before a phase change of the FG signal.

### (Bias Adjuster)

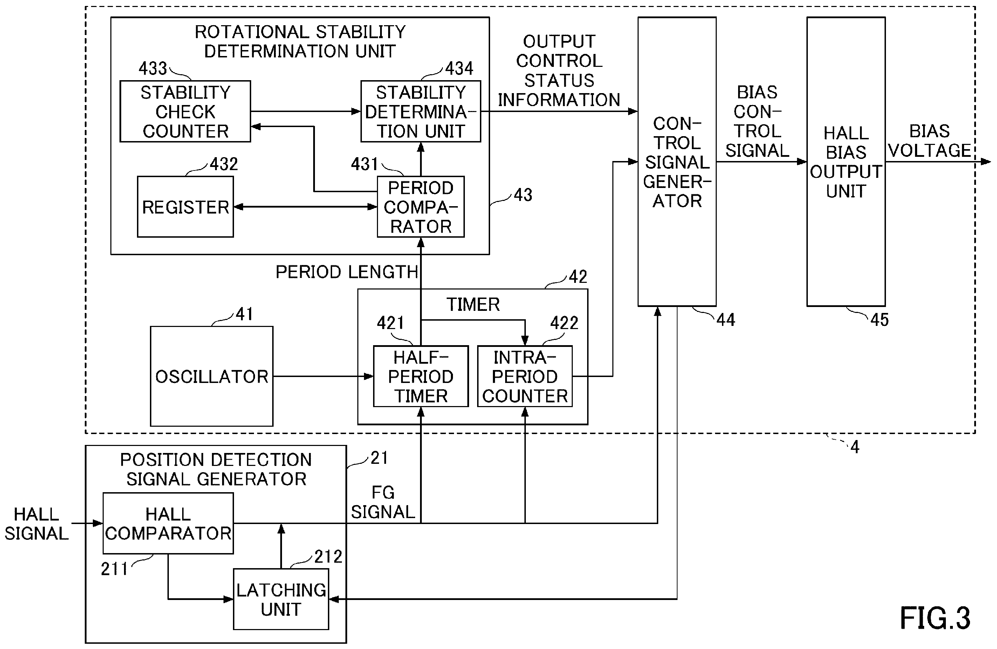

Hereinafter, the bias adjuster 4 and the position detection signal generator 21 will be described in detail with reference to FIG. 3. FIG. 3 is a functional block diagram illustrating the bias adjuster 4 and the position detection signal generator 21.

As described above, the bias adjuster 4 includes an oscillator 41, a timer 42, a rotation stability determination unit 43, a control signal generator 44, and a Hall bias output unit 45.

More specifically, the timer 42 includes a half-period timer 421 and an intra-period counter 422. The half-period timer 421 is a first measurement unit and measures a fluctuation period T of the magnetic field that is approximately equal to a rotation period of the rotor in the motor 5, that is, a half-period length that is a length of a half-period of the FG signal. The half-period timer 421 receives a clock from the oscillator 41, and operates continuously.

The intra-period counter 422 is a second measurement unit and counts an elapsed time within a current half-period of the FG signal. The intra-period counter 422 sets and measures a first period in the current half-period based on the product of a half-period length of an immediately preceding half-period measured by the half-period timer 421; and a predetermined value that is less than 1.

The rotation stability determination unit 43 includes a period comparator 431, a register 432, a stability check counter 433, and a stability determination unit 434.

The register 432 stores the half-period length of the immediately preceding half-period, and stores a specified value for the first time only. Each time an output logic of the FG signal is inverted, the register 432 registers a half-period length T as a measurement result, that is, overwrites a register value.

The period comparator 431 compares a current half-period length, measured by the half-period timer 421, with any one of a value of the immediately preceding half-period length stored in the register 432; and the specified value for the first time only. When period lengths of the immediately preceding half-period and the current half-period greatly vary, the period comparator 431 causes the stability determination unit 434 to determine that the bias output control is not required, and causes the control signal generator 44 to output a low-level signal.

The stability check counter 433 quantifies and counts a degree of stabilization. Specifically, the stability check counter 433 counts every time a change rate of the current half-period length relative to the immediately preceding half-period length is less than a predetermined value (d%). A predetermined value of the change rate is, for example, approximately 5% to 10%.

When a count value of the stability check counter 433 is equal to or greater than a predetermined value, the stability determination unit 434 determines that the bias output control is required because a change in the half-period length is small. Then, the stability determination unit 434 causes the control signal generator 44 to output a high-level signal. Specifically, the stability determination unit 434 controls the bias voltage to be less than a value that allows for magnetic field detection during a first period, if the change rate of the current half-period length relative to the immediately preceding half-period length is less than a predetermined value for a predetermined number of times (M times) or more. The predetermined number of times (M times) is, for example, 2 to 8.

The control signal generator 44 sets the control signal for the bias voltage to a high level, and outputs the control signal only if the rotational stability determination unit 43 determines that the control is required. In this case, in response to a phase change of the FG signal, the control signal generator 44 outputs the control signal for the bias voltage in a controlled state during a first period in the current half-period that is measured by the intra-period counter 422.

The first period, which is a period in which the control signal having the high level (in the controlled state) is output from the control signal generator 44, is shorter than the immediately preceding half-period length, and is equal to the immediately preceding half-period length excluding a specified proportion (1/N) thereof. That is, such a first period is defined by a product of the "immediately preceding half-period length" and a "predetermined value less than 1," expressed as T x (N-1)/N. The predetermined proportion (1/N) for the half-period is, for example, 1/4 to 1/10, and the predetermined value less than 1 is 3/4 to 9/10.

On the other hand, in the control signal generator 44, a second period, which is a period in which the control signal is output at a low level, is the remaining period from the end of the first period in the current half-period until a subsequent phase change of the FG signal (Hall signal).

The Hall bias output unit 45 controls and outputs the bias voltage to be less than a value that allows the Hall element 6 to detect the magnetic field while the control signal is output at the high level (in the controlled state), and outputs the bias voltage as a value that allows the Hall element 6 to detect the magnetic field while the control signal is output at the low level (which is not in the controlled state). Specifically, when the control signal is output at the high level, the Hall bias output unit 45 outputs the bias voltage as a second voltage value that is less than the first voltage value during the first period, and then outputs the bias voltage as a first voltage value that is a value allowing for the magnetic field detection during the second period in which the control signal is output at the low level.

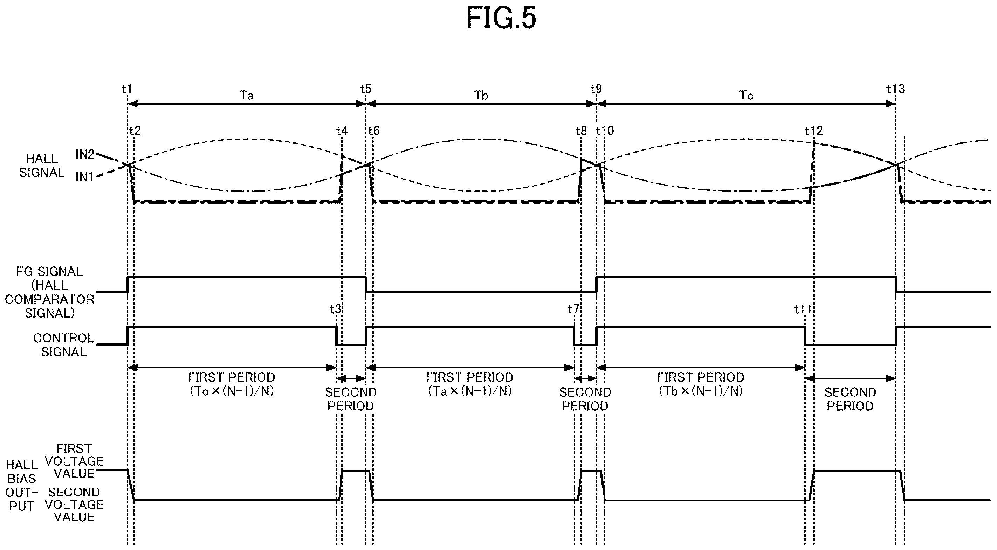

In this arrangement, during the second period, which is a period immediately before a subsequent phase change of the FG signal (Hall signals), the bias voltage is adjusted to the first voltage value that allows for the magnetic field detection. As a result, a timing of the phase change of the Hall signals can be detected without missing the timing. The control by the bias adjuster 4 will be described in detail with reference to FIGS. 5 to 7.

On the other hand, the position detection signal generator 21 includes a Hall comparator 211 and a latching unit 212. The Hall comparator 211 generates the FG signal. Under a condition in which the control signal is set to the L level and the electric field allowing for the magnetic field detection is applied to the Hall element 6, if the level of the Hall signal IN1 is higher than the level of the Hall signal IN2, the FG signal changes to the H level. In contrast, when the level of the Hall signal IN1 is lower than the level of the Hall signal IN2, the FG signal is maintained at the L level. The latching unit 212 latches the FG signal during a time period in which the control signal is high. Then, when the control signal becomes low, the latching unit 212 unlatches the FG signal.

### (Configuration of Hall Bias Output Unit)

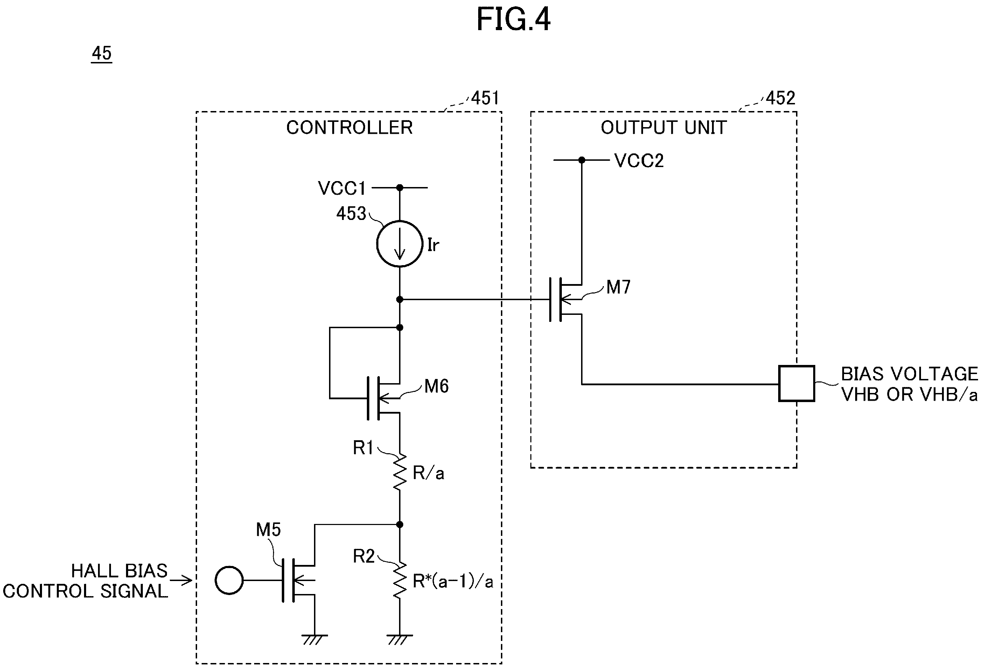

FIG. 4 is a circuit diagram illustrating the Hall bias output unit 45. The Hall bias output unit 45 includes a voltage controller 451 and an output unit 452. The voltage controller 451 includes a constant current source 453, P-channel FETs M5 and M6, and resistors R1 and R2. The constant current source 453 is, for example, a regulator whose output is stable. A P-channel FET M5 that is an input switch is connected between two resistors R1 and R2.

The output unit 452 includes a P-channel FET M7 connected to a power supply Vcc2. The P-channel FET M7 is an FET for reverse connection protection.

When the control signal is low, the P-channel FET M5 as the input switch is turned off, and the resulting voltage causes a current Ir generated by the constant current source 453 to flow into a ground line through both the resistor R1 having a resistance value of R/a and the resistor R2 having a resistance value of R × (a-1)/a. In this arrangement, when the control signal is low, the output unit 452 outputs the bias voltage defined by the current Ir x R, where the current Ir is generated by the constant current source.

When the control signal is high, the input switch M5 is turned on, and the resulting voltage causes the current Ir generated by the constant current source 453 to flow into a ground line through the resistor R1 having the resistance value of R/a. In this arrangement, when the control signal is high, the output unit 452 outputs the bias voltage derived from the current Ir x R/a, where the current Ir is generated by the constant current source.

That is, when the control signal is low (which is not in the controlled state), the input switch M5 is turned off, and as a result, the bias voltage is generated by multiplying the current generated by the constant current source by resistance values of the two resistors. On the other hand, when the control signal is high (which is in the control state), the input switch M5 is turned on, and as a result, the bias voltage is generated by multiplying the current generated by the constant current source by the resistance value of one of the two resistors.

With this approach, the bias voltage value of (Ir x R/a) when the control signal is high becomes 1/a of the bias voltage value of (Ir x R) when the control signal is low. Thus, the bias voltage value and power consumption associated with the bias voltage become smaller by Ir × R × {(a - 1)/a} than when the bias voltage value is expressed by Ir x R/a. For example, 1/a of the bias voltage that is set low is preferably 1/10 to 1/50, and therefore, the resistance value of the resistor R1 is much smaller than the resistance value of the resistor R2.

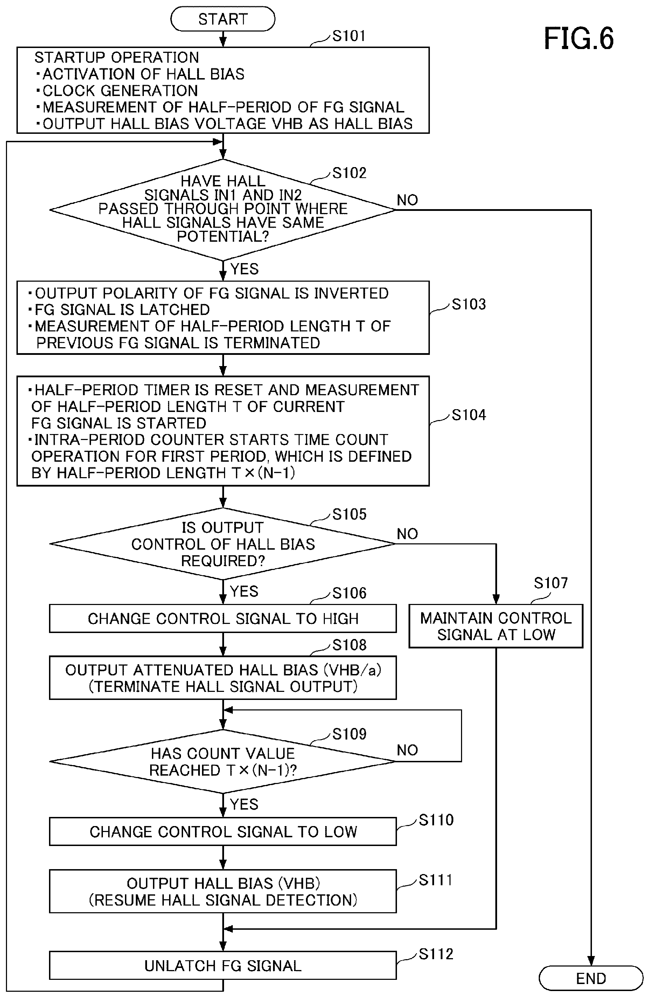

(Example of Bias Control in Steady State) Hereinafter, referring to FIGS. 5 and 6, a signal behavior when performing the bias control during steady-state rotation will be described. FIG. 5 is a diagram illustrating the signal behavior during the steady-state rotation in the motor drive controller according to one embodiment. FIG. 6 is an overall flowchart of the bias control according to the embodiment.

In a state where there is no bias control before entering the steady state, as a prerequisite startup operation, the Hall bias output unit 45 is started in step S101 to output, as the bias voltage, a first voltage value (VHB), which is a voltage value that allows the Hall element 6 to detect the magnetic field. Then, a clock is generated in the oscillator 41, and the half-period timer 421 constantly counts a half-period length, which is a length of the half-period of the FG signal.

In such a state, in step S102, when a point where the Hall signals IN1 and IN2 have the same potential is reached due to the rotation of the motor (change in the magnetic field), the point serves as a starting point of a given period, and the flow after step S103 starts.

When the Hall signals become the same potential in step S102, the output polarity of the FG signal, which is the position detection signal, is inverted in step S103. The latching unit 212 latches the FG signal immediately after the output polarity of the FG signal is inverted. In response to inverting the output polarity of the FG signal, the half-period timer 421 for counting the half-period finalizes the measurement of the half-period length (a previous half-period length T) of the FG signal at the timing of phase inversion.

In step 104, the half-period timer 421 is reset, and starts measurement of the half-period length of the FG signal in a current period. At the same time, the half-period length of the FG signal that has been measured in step 103 is input to the intra-period counter 422 as a length T of the half-period (half-period length), and the intra-period counter 422, which is a second measurement unit, starts counting a first period that extends to a duration expressed by the half-period length T × (N - 1), in the half-period.

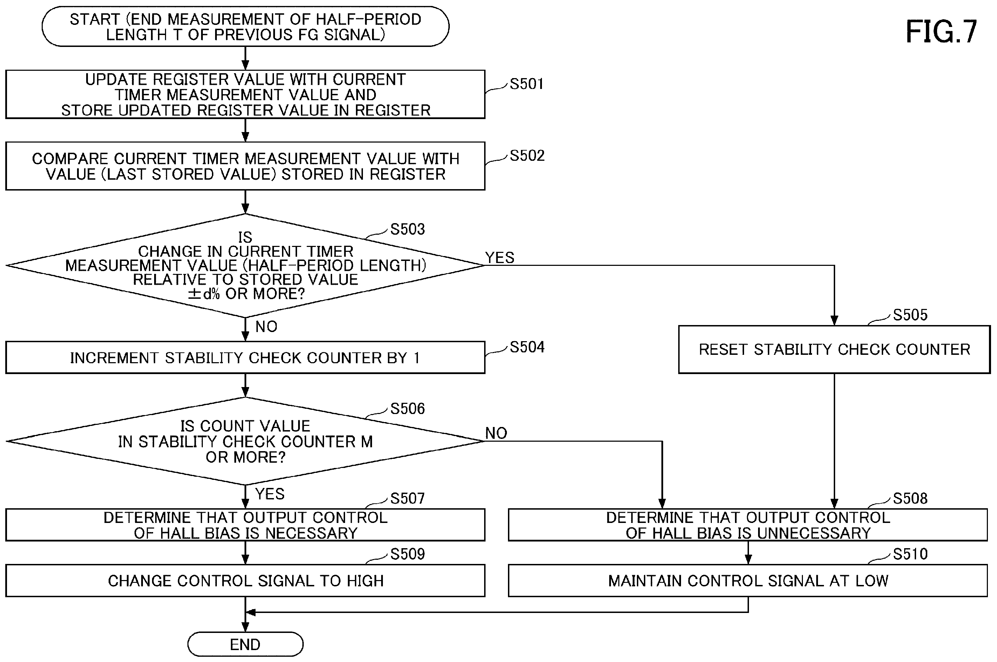

Then, in step 105, it is determined that the output control of the Hall bias is required. In response to inverting the FG signal in step 103, steps 104 and 105 are performed in parallel. The determination of an output control status will be described in detail with reference to FIG. 7.

If it is determined that the output control of the Hall bias in step 105 is required, the control signal becomes high in step 106.

Steps 102, 103, 104, 105, and 106 in FIG. 6 are performed at t1 in FIG. 5 with virtually no time difference.

On the other hand, if it is determined in step 105 that the output control of the Hall bias is not required, the control signal is maintained at the low level in step 107, and the process in steps 108 to 111 is not performed.

In response to changing the level of the control signal in step 106, the Hall bias output unit 45 attenuates the output voltage of the Hall bias to a second voltage value (VHB/a) in step 108. In conjunction with the above voltage attenuation, the Hall element 6 cannot detect the magnetic field due to an insufficient magnetic field, and the output of the Hall signal is stopped (step 108 is performed at t2 in FIG. 5).

In step S109, if a count value reaches a value expressed by T × (N-1) in the intra-period counter 422, it is assumed that the first period has ended, and the control signal for the Hall bias becomes low in step 110. (Steps 109 and 110 are performed at t3 in FIG. 5.).

When the control signal becomes low, the Hall bias output unit 45 outputs a first voltage value (VHB) that is a normal Hall bias voltage value in step 111. In response to this, the magnetic field becomes detectable, and the Hall element 6 enters a state (detection state) where the Hall element 6 can detect Hall signals.

In response to outputting the first voltage value (VHB) in step S111, a latched state of the FG signal is released in step S112. (Steps 111 and 112 are performed at t4 in FIG. 5).

Then, returning to step S102 (t5 in FIG. 5), if the point at which the Hall signals IN1 and IN2 have the same potential due to the rotation of the motor (change in the magnetic field) is reached, a second period within a given half-period ends simultaneously with the end of the given half-period.

At the same time, a timing of the point at which the Hall signals IN1 and IN2 have the same potential due to the rotation of the motor (change in the magnetic field) in step S102 (t5 in FIG. 5) is used as a starting point of a subsequent half-period. Then, the process in steps S102 to S112 is repeated.

Specifically, during a subsequent period Tb, steps S102, S103, S104, S105, and S106 are performed at t5; step S108 is performed at t6; steps S109 and S110 are performed at t7; and steps S111 and S112 are performed at t8. In a subsequent period Tc, S102, S103, S104, S105, and S106 are performed at t9; S108 is performed at t10; S109 and S110 are performed at t11; and S111 and S112 are performed at t12. With this approach, the process is repeated.

Here, the rotational speed of the single-phase motor 5 changes slightly due to external factors or the like, and thus half-period lengths of the half-periods Ta, Tb, and Tc of the FG signal change slightly. The first period, which is a bias voltage control period in which the output of the bias voltage is controlled to be reduced, is determined based on the half-period length of an immediately preceding half-period. In this arrangement, when the half-period length of the immediately preceding half-period is long and a current half-period is short, a percentage of a given first period in the immediately preceding half-period is increased, like the period Tb. On the other hand, when the immediately preceding half-period is short and the current half-period is long, the percentage of the first period in the half-period is decreased, like the period Tc.

As described above, according to the present embodiment, in the first period (derived from (N-1)/N), which is a period from immediately after detecting the phase change of the Hall signals until just before occurrence of a subsequent phase change, the Hall element outputs a second voltage value (VHB/a) that is obtained by controlling the bias voltage to be lower than a value allowing the Hall element to detect the magnetic field. On the other hand, during a second period other than the first period, the bias voltage that is set to the first voltage value (VHB) that allows for magnetic field detection is output.

During the control period of the bias output, phase change detection of the Hall signals is not performed, and the current consumption of the Hall bias output unit 45 is reduced.

For example, in the comparative example of FIG. 2, when the power voltage is 24 V, the regulator output voltage is 1.3 V, and the bias current is 5 mA, the Hall sensor consumes power of 6.5 mW, derived from 1.3 V x 5 mA, and the regulator output unit consumes power of 113.5 mW, derived from (24 V - 1.3 V) × 5mA.

On the other hand, according to the present embodiment, the power consumption of the Hall bias when the rotation of the motor is stable can be reduced by (N-1) /N × (1 - 1/a²) × 100 (%) as compared to when there is no Hall bias control. Here, when the control of the present embodiment is executed under the same condition as in FIG. 2, for example, when N = 8 and a = 30, the power consumption becomes 15.1 mW (12.6 %), and the power consumption of the Hall bias can be reduced by 87.4 %. As described above, by controlling the Hall bias voltage according to the present embodiment, the power consumption of the Hall bias can be greatly reduced as compared with when there is no Hall bias control.

As described above, in the present embodiment, the Hall sensor is biased only in the vicinity of a required timing to detect a timing of the phase change. As a result, the bias current during an unnecessary period can be reduced, and the power consumption can be greatly suppressed.

In addition, the bias voltage itself is maintained even during an unnecessary period of detection by the Hall sensor, and thus on-off switching does not occur and switching noise does not occur. By maintaining an idling current with a low bias voltage value, the operation can smoothly transition to an intended mode after returning to a high bias voltage value.

However, during a rotation unstable state such as startup or deceleration for shutdown, rather than a steady state, there may be significant changes in FG periods before and after because one or more FG periods are unstable. For example, in an operating mode in which acceleration of a rotational speed increases, such as startup or rotational speed changes, when the Hall bias control of the present embodiment is performed, such as when the rotation speed is started or when the rotation speed control input changes (change in a rotation speed), a phase change of the Hall signals occurs during a half-period, derived from (N-1)/N, in which the bias voltage is set low with reference to the immediately preceding half-period. As a result, a fluctuation period T of the magnetic field may not be detected accurately, and thus the FG signal may fail to switch.

Therefore, according to the present embodiment, the Hall bias control is not performed during the following periods: a period from the start of the motor until the rotation speed of the motor stabilizes, a period from the input of a control command to change the speed until the motor speed stabilizes, and a period from the detection of a motor lock to restart the motor until the rotation speed of the motor stabilizes. That is, the first voltage value VHB, which is a Hall bias voltage allowing for continuous magnetic field detection, is output to bias the Hall sensor.

Then, it is determined whether to perform control to reduce the bias voltage, and the Hall bias control is performed only when the rotation speed stabilizes.

Hereinafter, the determination of whether to perform control to reduce the bias voltage will be described with reference to FIGS. 3 and 7. FIG. 7 is a detailed flowchart for the determination whether to perform the bias control according to the present embodiment. The determination related with the bias control is performed at the timing of S105 in FIG. 6, that is, between t1 and t2 in FIG. 5.

In an unstable period before entering the steady state, the half-period timer 421 constantly counts the half-period length in accordance with an output clock, the Hall bias output unit 45 outputs the first voltage value VHB, which is a normal Hall bias voltage. A predetermined maximum value is set in the register 432.

The flow of FIG. 7 is executed in parallel with S104 upon completion of the period measurement by the half-period timer 421 in S103 in FIG. 6.

In step S501, the register 432 updates a register value with the current half-period length that is measured by the current half-period timer 421, and stores the updated register value.

In parallel with S501, in S502, the stability determination unit 434 compares the current (immediately preceding) half-period length (measurement value) by the half-period timer 421, with a stored value in the register 432. The stored value in the register 432 roughly corresponds to the half-period length of the previous cycle. However, if this process is first executed, the maximum value set in the register 432 is used instead of the stored value in the register 432.

In step 503, if a change in the half-period length, which is a current timer measurement value, relative to the above stored value is ±d% or more, it is determined that the rotation is unstable, and in step 505, the count value of the stability check counter 433 is reset to zero. In step 508, the stability determination unit 434 determines that the output control of the Hall bias is not required. With this approach, if it is determined that the output control of the Hall bias is not required, the output control signal is maintained at the low level (step 510).

On the other hand, if the result is NO in step 503, it is determined that the change in the current half-period length relative to the previous half-period length is small, and in step 504, the count value of the stability check counter 433 is incremented by 1.

Thereafter, it is determined whether the count value of the stability check counter 433 incremented in step 505 is equal to or greater than M (M is a natural number equal to or greater than 2). If the count value is equal to or greater than M (YES), the stability determination unit 434 determines that the output control of the Hall bias is required (step 507). Then, the control signal to control the Hall bias output is set to the high level (step 509).

As described above, in addition to the fact that variations are small by comparing the current half-period length with the previous half-period length in step 503, the output of a second voltage value during the first period, which is in the bias control of an attenuated voltage, is started after it is confirmed in step 505 that an accumulative change in half-period lengths is small for M or more half-periods.

With this arrangement, in the present embodiment, by performing the Hall bias control only in a state where the rotational speed is stable while suppressing the power consumption, a given timing of switching the FG signal can be reliably and accurately detected without missing the given timing of signal switching. As a result, the motor can be driven and controlled.

### (First Modification)

In the embodiments, although the magnetic sensor for detecting the magnetic field of the motor is described using an example of the Hall element, a specific type of magnetic sensor capable of detecting the magnetic field of a rotating motor as a magnetic signal is not limited, and any other magnetic sensor such as a magneto resistance (MR) sensor may be used.

### (Second Modification)

In FIG. 1, each switch of the H-bridge circuit is described using the FET, but the switch of the H-bridge may be a bipolar transistor.

### (Third Modification)

In the motor driver of the motor drive controller in the present disclosure, not only to a single-channel H-bridge but also a 1.5-channel H-bridge (three half-bridges) can apply to the BLDC motor.

In the present disclosure, a motor drive controller reliably detects a timing of a phase change of magnetic signals, and reduces a bias current during an unnecessary period without generating switching noise, thereby suppressing power consumption.

## Claims

1. A motor drive controller (1) for driving a brushless direct current (DC) motor (5), comprising:
a motor drive unit configured to drive the brushless DC motor;
a magnetic sensor (6) configured to detect a magnetic field generated by rotation of the brushless DC motor and output the magnetic field as each of magnetic signals; and
a bias adjustment unit (4) configured to adjust and output a bias voltage used in magnetic field detection that is performed by the magnetic sensor,
wherein the bias adjustment unit is configured to
measure a half-period length corresponding to a phase change of the magnetic signals;
adjust the bias voltage to a second voltage value lower than a first voltage value that allows the magnetic sensor to detect the magnetic field, during a first period after a phase change of the magnetic signals, and
adjust the bias voltage to the first voltage value during a second period from an end of the first period until a subsequent phase change of the magnetic signals,
**characterized in that**
the bias adjustment unit includes a rotational stability determination unit (43) configured to compare an immediately preceding half-period length with a half-period length before the immediately preceding half-period length, to determine whether to adjust the bias voltage,
wherein the immediately preceding half-period length and the half-period before the immediately preceding half-period length are measured by a first measurement unit (421), the immediately preceding half-period being measured immediately before the phase change of the magnetic signal.

2. The motor drive controller (1) according to claim 1, further comprising:
a signal generation unit configured to output a position detection signal whose phase changes in response to the phase change of the magnetic signals generated by the magnetic sensor (6),
wherein the bias adjustment unit (4) includes
the first measurement unit (421) configured to measure a half-period length of the position detection signal, and
a second measurement unit (422) configured to measure a first period in a current half-period, based on a product of a half-period length of an immediately preceding measured half-period and a predetermined value that is less than 1.

3. The motor drive controller (1) according to claim 2, wherein the bias adjustment unit (4) includes
a control signal generator (44) configured to output, in a controlled state, a control signal to control the bias voltage during the first period in the current half-period measured by the second measurement unit, in response to a phase change of the positional detection signal, and
a bias output unit (45) configured to output the bias voltage as the second voltage value while outputting the control signal in the controlled state.

4. The motor drive controller (1) according to claim 3, wherein the bias output unit (45) includes an input terminal, a constant current source (453), two resistors, and an input switch coupled between the two resistors,
wherein upon occurrence of a condition in which the control signal is not in the controlled state,
the input switch is configured to be turned off such that the bias voltage is generated by multiplying a current generated by the constant current source by a resistance value that is obtained using the two resistors, and
wherein upon occurrence of a condition in which the control signal is in the controlled state, the input switch is configured to be turned on, and the bias voltage is generated by multiplying the current generated by the constant current source by a resistance value of one of the two resistors.

5. The motor drive controller (1) according to claim 1, wherein the bias adjustment unit (4) is configured not to adjust the bias voltage to the second voltage value during the first period in a current half-period, upon occurrence of a condition in which a change rate of the immediately preceding half-period length relative to the half-period before the immediately preceding half-period length is equal to or greater than a predetermined value.

6. The motor drive controller (1) according to claim 1, wherein the rotational stability determination unit (43) includes a stability check counter (433) configured to count every time the change rate of the current half-period length relative to an immediately preceding half-period length becomes less than a predetermined value, and
wherein the rotational stability determination unit is configured to adjust the bias voltage to the second voltage value during the first period in the current half-period, upon occurrence of a condition in which the change rate of the first half-period length relative to the second half-period length is less than a predetermined value for a predetermined number of consecutive occurrences or more.

7. A method for controllably driving a motor, for applying a drive voltage to a brushless direct current (DC) motor (5) via a motor drive unit (3), comprising:
outputting a position detection signal whose phase changes by a phase change of magnetic signals that are generated by a magnetic sensor (6);
measuring, by a first counter (421), a half-period length corresponding to a phase change of the position detection signal;
measuring, by a second counter (422), a first period in a current half-period, based on a product of a half-period length immediately before the first counter measures the half-period length and a predetermined value that is less than 1; and
adjusting and outputting a bias voltage used in magnetic field detection that is performed by the magnetic sensor,
wherein the adjusting of the bias voltage includes,
adjusting, during the first period after the phase change of the magnetic signals, the bias voltage to a second voltage value that is lower than a first voltage value that allows the magnetic sensor to detect the magnetic field,
adjusting, during a second period from an end of the first period until a subsequent phase change of the magnetic signals, the bias voltage to the first voltage value,
**characterized in that**
the adjusting of the bias voltage further includes comparing an immediately preceding half-period length with a half-period length before the immediately preceding half-period length, to determine whether to adjust the bias voltage,
wherein the immediately preceding half-period length and a half-period before the immediately preceding half-period length are measured by the first counter, the immediately preceding half-period being measured immediately before the phase change of the magnetic signal.

## Patentansprüche

1. Motorantriebssteuerung (1) zum Antreiben eines bürstenlosen Gleichstrom-(DC-)Motors (5), umfassend:
eine Motorantriebseinheit, die dazu konfiguriert ist, den bürstenlosen DC-Motor anzutreiben;
einen Magnetsensor (6), der dazu konfiguriert ist, ein durch eine Drehung des bürstenlosen DC-Motors erzeugtes Magnetfeld zu detektieren und das Magnetfeld als jeweilige Magnetsignale auszugeben; und
eine Bias-Anpassungseinheit (4), die dazu konfiguriert ist, eine bei der Magnetfelddetektion, die von dem Magnetsensor durchgeführt wird, verwendete Bias-Spannung auszugeben,
wobei die Bias-Anpassungseinheit dazu konfiguriert ist, eine Halbperiodenlänge, die einer Phasenänderung der Magnetsignale entspricht, zu messen;
die Bias-Spannung auf einen zweiten Spannungswert, der niedriger als ein erster Spannungswert ist, anzupassen, der es dem Magnetsensor ermöglicht, das Magnetfeld während einer ersten Periode nach einer Phasenänderung der Magnetsignale zu detektieren, und
die Bias-Spannung während einer zweiten Periode ab einem Ende der ersten Periode bis zu einer nachfolgenden Phasenänderung der Magnetsignale auf den ersten Spannungswert anzupassen,
**gekennzeichnet dadurch, dass**
die Bias-Anpassungseinheit eine Drehstabilitätsbestimmungseinheit (43) beinhaltet, die dazu konfiguriert ist, eine unmittelbar vorhergehende Halbperiodenlänge mit einer Halbperiodenlänge vor der unmittelbar vorhergehenden Halbperiodenlänge zu vergleichen, um zu bestimmen, ob die Bias-Spannung angepasst werden soll,
wobei die unmittelbar vorhergehende Halbperiodenlänge und die Halbperiodenlänge vor der unmittelbar vorhergehenden Halbperiodenlänge durch eine erste Messeinheit (421) gemessen werden,
wobei die unmittelbar vorhergehende Halbperiodenlänge unmittelbar vor der Phasenänderung des Magnetsignals gemessen wird.

2. Motorantriebssteuerung (1) nach Anspruch 1, ferner umfassend:
eine Signalerzeugungseinheit, die dazu konfiguriert ist, ein Positionsdetektionssignal auszugeben, dessen Phase sich als Antwort auf die Phasenänderung der durch den Magnetsensor (6) erzeugten Magnetsignale ändert,
wobei die Bias-Anpassungseinheit (4) Folgendes beinhaltet:
die erste Messeinheit (421), die dazu konfiguriert ist, eine Halbperiodenlänge des Positionsdetektionssignals zu messen, und
eine zweite Messeinheit (422), die dazu konfiguriert ist, eine erste Periode in einer Stromhalbperiode auf Basis eines Produkts einer Halbperiodenlänge einer unmittelbar vorhergehend gemessenen Halbperiode und eines vorbestimmten Wertes, der kleiner als 1 ist, zu messen.

3. Motorantriebssteuerung (1) nach Anspruch 2, wobei die Bias-Anpassungseinheit (4) Folgendes beinhaltet:
eine Steuersignalerzeugungsvorrichtung (44), die dazu konfiguriert ist, in einem gesteuerten Zustand ein Steuersignal auszugeben, um die Bias-Spannung während der ersten Periode in der durch die zweite Messeinheit gemessenen Stromhalbperiode als Antwort auf eine Phasenänderung des Positionsdetektionssignals zu steuern, und
eine Bias-Ausgabeeinheit (45), die dazu konfiguriert ist, die Bias-Spannung als den zweiten Spannungswert auszugeben, während das Steuersignal in dem gesteuerten Zustand ausgegeben wird.

4. Motorantriebssteuerung (1) nach Anspruch 3, wobei die Bias-Ausgabeeinheit (45) einen Eingabeanschluss, eine konstante Stromquelle (453), zwei Widerstände und einen zwischen den zwei Widerständen gekoppelten Eingabeschalter beinhaltet,
wobei bei Auftreten eines Umstands, in dem das Steuersignal nicht in dem gesteuerten Zustand ist,
der Eingabeschalter dazu konfiguriert ist, ausgeschaltet zu sein, sodass die Bias-Spannung durch Multiplizieren eines von der konstanten Stromquelle erzeugten Stroms mit einem Widerstandswert, der unter Verwendung der zwei Widerstände erhalten wird, erzeugt wird, und
wobei bei Auftreten eines Umstands, in dem das Steuersignal in dem gesteuerten Zustand ist, der Eingabeschalter dazu konfiguriert ist, eingeschaltet zu sein, und die Bias-Spannung durch Multiplizieren eines von der konstanten Stromquelle erzeugten Stroms mit einem Widerstandswert von einem der zwei Widerstände erzeugt wird.

5. Motorantriebssteuerung (1) nach Anspruch 1, wobei die Bias-Anpassungseinheit (4) dazu konfiguriert ist, die Bias-Spannung während der ersten Periode in einer Stromhalbperiode nicht auf den zweiten Spannungswert anzupassen, bei Auftreten eines Umstands, in dem eine Änderungsrate der unmittelbar vorhergehenden Halbperiodenlänge relativ zu der Halbperiode vor der unmittelbar vorhergehenden Halbperiodenlänge gleich oder größer als ein vorbestimmter Wert ist.

6. Motorantriebssteuerung (1) nach Anspruch 1, wobei die Drehstabilitätsbestimmungseinheit (43) einen Stabilitätsprüfzähler (433) beinhaltet, der dazu konfiguriert ist, jedes Mal zu zählen, wo die Änderungsrate der Stromhalbperiodenlänge relativ zu einer unmittelbar vorhergehenden Halbperiodenlänge kleiner als ein vorbestimmter Wert wird, und
wobei die Drehstabilitätsbestimmungseinheit dazu konfiguriert ist, die Bias-Spannung während der ersten Periode in der Stromhalbperiode auf den zweiten Spannungswert anzupassen, bei Auftreten eines Umstands, in dem die Änderungsrate der ersten Halbperiodenlänge relativ zu der zweiten Halbperiodenlänge für eine vorbestimmte Anzahl von aufeinanderfolgenden Auftritten oder mehr kleiner als ein vorbestimmter Wert ist.

7. Verfahren zum steuerbaren Antreiben eines Motors zum Anlegen einer Antriebsspannung an einem bürstenlosen Gleichstrom-(DC-)Motor (5) über eine Motorantriebseinheit (3), umfassend:
Ausgeben eines Positionsdetektionssignals, dessen Phase sich durch eine Phasenänderung von Magnetsignalen, die durch den Magnetsensor (6) erzeugt werden, ändert;
Messen, durch einen ersten Zähler (421), einer Halbperiodenlänge, die einer Phasenänderung des Positionsdetektionssignals entspricht;
Messen, durch einen zweiten Zähler (422), einer ersten Periode in einer Stromhalbperiode auf Basis eines Produkts einer Halbperiodenlänge, unmittelbar bevor der erste Zähler die Halbperiodenlänge misst, und eines vorbestimmten Wertes, der kleiner als 1 ist; und
Anpassen und Ausgeben einer Bias-Spannung, die bei einer Magnetfelddetektion verwendet wird, die von dem Magnetsensor durchgeführt wird,
wobei das Anpassen der Bias-Spannung Folgendes beinhaltet:
Anpassen, während der ersten Periode nach der Phasenänderung der Magnetsignale, der Bias-Spannung auf einen zweiten Spannungswert, der niedriger als der erste Spannungswert ist und der es dem Magnetsensor ermöglicht, das Magnetfeld zu detektieren,
Anpassen, während einer zweiten Periode ab einem Ende der ersten Periode bis zu einer nachfolgenden Phasenänderung der Magnetsignale, der Bias-Spannung auf den ersten Spannungswert,
**gekennzeichnet dadurch, dass**
das Anpassen der Bias-Spannung ferner das Vergleichen einer unmittelbar vorhergehenden Halbperiodenlänge mit einer Halbperiodenlänge vor der unmittelbar vorhergehenden Halbperiodenlänge beinhaltet, um zu bestimmen, ob die Bias-Spannung angepasst werden soll,
wobei die unmittelbar vorhergehende Halbperiodenlänge und eine Halbperiodenlänge vor der unmittelbar vorhergehenden Halbperiodenlänge durch den ersten Zähler gemessen werden, wobei die unmittelbar vorhergehende Halbperiodenlänge unmittelbar vor der Phasenänderung des Magnetsignals gemessen wird.

## Revendications

1. Contrôleur d'entraînement de moteur (1) pour entraîner un moteur à courant continu (CC) sans balai (5), comprenant :
une unité d'entraînement de moteur configurée pour entraîner le moteur à CC sans balai ;
un capteur magnétique (6) configuré pour détecter un champ magnétique généré par rotation du moteur à CC sans balai et délivrer en sortie le champ magnétique en tant que chacun des signaux magnétiques ; et
une unité d'ajustement de polarisation (4) configurée pour ajuster et délivrer en sortie une tension de polarisation utilisée dans la détection de champ magnétique qui est réalisée par le capteur magnétique,
dans lequel l'unité d'ajustement de polarisation est configurée pour mesurer une durée de demi-période correspondant à un changement de phase des signaux magnétiques;
ajuster la tension de polarisation à une deuxième valeur de tension inférieure à une première valeur de tension qui permet au capteur magnétique de détecter le champ magnétique, pendant une première période après un changement de phase des signaux magnétiques, et
ajuster la tension de polarisation à la première valeur de tension pendant une deuxième période à partir d'une fin de la première période jusqu'à un changement de phase ultérieur des signaux magnétiques,
**caractérisé en ce que**
l'unité d'ajustement de polarisation inclut une unité de détermination de stabilité de rotation (43) configurée pour comparer une durée de demi-période immédiatement précédente à une durée de demi-période avant la durée de demi-période immédiatement précédente, pour déterminer s'il convient d'ajuster la tension de polarisation,
dans lequel la durée de demi-période immédiatement précédente et la demi-période avant la durée de demi-période immédiatement précédente sont mesurées par une première unité de mesure (421), la demi-période immédiatement précédente étant mesurée immédiatement avant le changement de phase du signal magnétique.

2. Contrôleur d'entraînement de moteur (1) selon la revendication 1, comprenant en outre :
une unité de génération de signal configurée pour délivrer en sortie un signal de détection de position dont la phase change en réponse au changement de phase des signaux magnétiques générés par le capteur magnétique (6),
dans lequel l'unité d'ajustement de polarisation (4) inclut
la première unité de mesure (421) configurée pour mesurer une durée de demi-période du signal de détection de position, et
une deuxième unité de mesure (422) configurée pour mesurer une première période dans une demi-période en cours, sur la base d'un produit d'une durée de demi-période d'une demi-période mesurée immédiatement précédente et d'une valeur prédéterminée qui est inférieure à 1.

3. Contrôleur d'entraînement de moteur (1) selon la revendication 2, dans lequel l'unité d'ajustement de polarisation (4) inclut
un générateur de signal de contrôle (44) configuré pour délivrer en sortie, dans un état contrôlé, un signal de contrôle pour contrôler la tension de polarisation pendant la première période dans la demi-période en cours mesurée par la deuxième unité de mesure, en réponse à un changement de phase du signal de détection de position, et
une unité de sortie de polarisation (45) configurée pour délivrer en sortie la tension de polarisation en tant que la deuxième valeur de tension tout en délivrant en sortie le signal de contrôle dans l'état contrôlé.

4. Contrôleur d'entraînement de moteur (1) selon la revendication 3, dans lequel l'unité de sortie de polarisation (45) inclut un terminal d'entrée, une source de courant constante (453), deux résistances et un commutateur d'entrée couplé entre les deux résistances,
dans lequel lors de la survenance d'une condition dans laquelle le signal de contrôle n'est pas dans l'état contrôlé,
le commutateur d'entrée est configuré pour être désactivé de telle sorte que la tension de polarisation est générée par la multiplication d'un courant généré par la source de courant constante par une valeur de résistance qui est obtenue en utilisant les deux résistances, et
dans lequel lors de la survenance d'une condition dans laquelle le signal de contrôle est dans l'état contrôlé, le commutateur d'entrée est configuré pour être activé, et la tension de polarisation est générée par la multiplication du courant généré par la source de courant constante par une valeur de résistance d'une des deux résistances.

5. Contrôleur d'entraînement de moteur (1) selon la revendication 1, dans lequel l'unité d'ajustement de polarisation (4) est configurée pour ne pas ajuster la tension de polarisation à la deuxième valeur de tension pendant la première période d'une demi-période en cours, lors de la survenance d'une condition dans laquelle un taux de changement de la durée de demi-période immédiatement précédente par rapport à la demi-période avant la durée de demi-période immédiatement précédente est supérieur ou égal à une valeur prédéterminée.

6. Contrôleur d'entraînement de moteur (1) selon la revendication 1, dans lequel l'unité de détermination de stabilité de rotation (43) inclut un compteur de vérification de stabilité (433) configuré pour compter chaque fois que le taux de changement de la durée de demi-période en cours par rapport à une durée de demi-période immédiatement précédente devient inférieur à une valeur prédéterminée, et
dans lequel l'unité de détermination de stabilité de rotation est configurée pour ajuster la tension de polarisation à la deuxième valeur de tension pendant la première période de la demi-période en cours, lors de la survenance d'une condition dans laquelle le taux de changement de la première durée de demi-période par rapport à la deuxième durée de demi-période est inférieur à une valeur prédéterminée pendant un nombre prédéterminé de survenances consécutives ou plus.

7. Procédé pour entraîner de manière contrôlée un moteur, pour appliquer une tension d'entraînement à un moteur à courant continu (CC) sans balai (5) via une unité d'entraînement de moteur (3), comprenant :
la délivrance en sortie d'un signal de détection de position dont la phase change en fonction d'un changement de phase de signaux magnétiques qui sont générés par un capteur magnétique (6) ;
la mesure, par un premier compteur (421), d'une durée de demi-période correspondant à un changement de phase du signal de détection de position ;
la mesure, par un deuxième compteur (422), d'une première période dans une demi-période en cours, sur la base d'un produit d'une durée de demi-période immédiatement avant que le premier compteur mesure la durée de demi-période et d'une valeur prédéterminée qui est inférieure à 1 ; et
l'ajustement et la délivrance en sortie d'une tension de polarisation utilisée dans la détection de champ magnétique qui est réalisée par le capteur magnétique,
dans lequel l'ajustement de la tension de polarisation inclut,
l'ajustement, pendant la première période après le changement de phase des signaux magnétiques, de la tension de polarisation à une deuxième valeur de tension qui est inférieure à une première valeur de tension qui permet au capteur magnétique de détecter le champ magnétique,
l'ajustement, pendant une deuxième période à partir d'une fin de la première période jusqu'à un changement de phase ultérieur des signaux magnétiques, de la tension de polarisation à la première valeur de tension,
**caractérisé en ce que**
l'ajustement de la tension de polarisation inclut en outre la comparaison d'une durée de demi-période immédiatement précédente avec une durée de demi-période avant la durée de demi-période immédiatement précédente, pour déterminer s'il convient d'ajuster la tension de polarisation,
dans lequel la durée de demi-période immédiatement précédente et une demi-période avant la durée de demi-période immédiatement précédente sont mesurées par le premier compteur, la demi-période immédiatement précédente étant mesurée immédiatement avant le changement de phase du signal magnétique.
